# EUROPEAN PATENT APPLICATION

(11) **EP 0 586 149 A1**
(43) Date of publication of application: **09.03.1994**
(21) Application number: 93306586.4
(22) Date of filing: 19.08.1993
(51) Int. Cl.: H01L 21/316, H01L 21/312, H01L 21/56, H01L 23/29, H01L 23/485, C04B 41/50, C04B 41/45

(54) **Hermetic protection for integrated circuits, based on a ceramic layer**

(30) Priority: 31.08.1992 US 937007
(71) Applicant: DOW CORNING CORPORATION, Midland Michigan 48686-0994 (US)
(72) Inventor: Chandra, Grish, Midland, Michigan (US); Michael, Keith Winton, Midland, Michigan (US)
(74) Representative: Laredo, Jack Joseph

(57) **Abstract**

This invention relates to integrated circuits which are protected from the environment. Such circuits are hermetically sealed by applying additional ceramic layers to the primary passivation.

## Description

The present invention relates to integrated circuits which are protected from the environment. Such circuits are hermetically sealed by applying additional ceramic layers to the primary passivation. These circuits are inexpensive to fabricate and have improved performance and reliability.

Modern electronic circuits must be able to withstand a wide variety of environmental conditions such as moisture, ions, heat and abrasion. A significant amount of work has been directed toward various protective measures to minimize the exposure of such circuits to the above conditions and thereby increase their reliability and life.

Many prior art processes for protecting electronic circuits involve sealing or encapsulating the circuits after they have been interconnected. For example, it is known in the art to use protective layers of silicones, polyimides, epoxies, other organics, plastics and the like. Such materials, however, are of only limited value since most are permeable to environmental moisture and ions.

Similarly, interconnected circuits have also been sealed within ceramic packages. This latter approach has proven to be relatively effective in increasing device reliability and is currently used in select applications. The added size, weight and cost involved in this approach, however, inhibits widespread application in the electronic industry.

The use of lightweight ceramic protective coatings on electronic devices has also been suggested in U.S. Patents 4,756,977 and 4,749,631. The use of ceramic silica coatings are described therein which are derived from hydrogen silsesquioxane and silicate esters, respectively, as well as the use of additional ceramic layers as hermetic barriers. We have discovered that when such coatings are applied specifically to integrated circuits at the wafer stage and, even though the bond pads are subsequently opened by removing a portion of the coating, the resultant circuits remain hermetically sealed and exhibit increased reliability and life.

Sealing circuits at the wafer stage is also known in the art. For example, it is known in the art to coat fabricated integrated circuits with ceramic materials such as silica and/or silicon nitride by chemical vapor deposition (CVD) techniques. These coatings are then etched back to the bond pads for the application of leads. The wafers coated in this manner, however, have inadequate reliability and life.

We have found a solution to the above problems associated with the hermetic protection of integrated circuits by providing the CVD applied ceramic layers with further ceramic coatings that seal.

The present invention relates to hermetically sealed integrated circuits. These circuits comprise circuit subassemblies having a primary passivation and one or more bond pads opened in the passivation. To this primary passivation is applied a silicon-containing ceramic layer by a process comprising coating the circuit with a composition comprising a preceramic silicon-containing material followed by converting said material to a ceramic.

The present invention also relates to a method for producing the above sealed integrated circuits. The method involves applying one or more ceramic layers over the circuit subassembly followed by removing at least a portion of the ceramic layer covering the bond pads.

The present invention is based on our finding that integrated circuits can be hermetically sealed by the application of a ceramic seal over the primary passivation. These sealed circuits have increased reliability and performance. In addition, since this process is unexpectedly performed at the wafer stage, production can be simplified and costs reduced.

The integrated circuit subassemblies used in the process of this invention are not critical and nearly any which are known in the art and/or produced commercially are useful herein. The processes used to produce such circuits are also known and not critical to the invention. Exemplary of such circuits are those comprising a semiconductor substrate, such as silicon or gallium arsenide, having an epitaxial layer grown thereon. This epitaxial layer is appropriately doped to form the PN-junction regions which constitute the active regions of the device. These active regions are diodes and transistors which form the integrated circuit when appropriately interconnected by a properly patterned metallic layer. This metallic interconnect layer terminates at the bond pads on the exterior surface of the circuit subassembly. To protect the exterior surface of the circuit, a primary passivation is applied and the passivation then etched back at the bond pads to allow subsequent dicing and interconnection of the circuit to form the active device. These processes are generally performed at the wafer stage.

The passivation described above conventionally comprises one or more ceramic coatings applied by CVD techniques. These coatings can comprise, for example, silica, silicon nitride or silicon oxynitride derived from precursors such as silane and oxygen, nitrous oxide, nitrogen, ammonia or the like.

Despite the fact that these circuits have a passivation layer, they are still prone to damage by the environment. For example, the passivation is prone to penetration of water and/or various destructive ions through defects and cracks. As noted above, the circuit industry has attempted to solve these problems by the use of additional protective measures after the circuits are interconnected. The present invention, on the other hand, describes additional measures to be taken before interconnection of the circuit.

In the process of the present invention, the above circuits are sealed by covering the primary passivation with one or more additional ceramic layers. The first layer is generally a silicon-containing ceramic material which is applied by a process comprising coating the circuit with a composition comprising a preceramic silicon-containing material followed by converting the preceramic silicon-containing material to a ceramic. Typically, the preceramic material is converted to a ceramic by heating it to a sufficient temperature.

As used in the present invention, the term "preceramic silicon-containing material" describes materials which can be rendered sufficiently flowable to impregnate and coat the surface of a circuit and which can be subsequently converted to a solid layer exhibiting properties generally recognized by those skilled in the art as characteristic of a ceramic. These materials include, for example, precursors to silicon oxides, silicon nitride, silicon oxynitride, silicon oxycarbide, silicon carbonitride, silicon oxycarbonitride, silicon carbide and the like.

The preferred preceramic compounds to be used in the process of this invention are precursors to silicon oxides, especially silica. The silica precursors which may be used in the invention include hydrogen silsesquioxane resin (H-resin), hydrolyzed or partially hydrolyzed RₙSi(OR)₄₋ₙ, or their combinations, in which each R is independently an aliphatic, alicyclic or aromatic substituent of 1-20 carbon atoms, preferably 1-4 carbon atoms, such as an alkyl (e.g., methyl, ethyl, propyl), alkenyl (e.g., vinyl or allyl), alkynyl (e.g., ethynyl), cyclopentyl, cyclohexyl and phenyl and n is 0-3, preferably 0-1.

H-resin is used in this invention to describe a variety of hydridosilane resins having units of the structure HSi(OH)ₓ(OR)_{y}O_{z/2} in which each R is independently an organic group which, when bonded to silicon through the oxygen atom, forms a hydrolyzable substituent, x = 0-2, y = 0-2, z = 1-3 and x + y + z = 3. These resins may be either fully condensed (x = 0, y = 0 and z = 3) or they may be only partially hydrolyzed (y is not 0 over all the units of the polymer) and/or partially condensed (x is not 0 over all the units of the polymer). Although not represented by this structure, various units of these resins may have either zero or more than one Si-H bond due to various factors involved in their formation and handling. Exemplary of substantially condensed (less than about 300 ppm silanol) H-resins are those formed by the process in U.S. Patent 3,615,272. This polymeric material has units of the formula (HSiO_{3/2})ₙ in which n is generally 8-1000. The preferred resin has a number average molecular weight of from 800-2900 and a weight average molecular weight of between 8000-28,000 (obtained by gel permeation chromatography (GPC) analysis using polydimethylsiloxane as a calibration standard). When heated sufficiently, this material yields a ceramic coating essentially free of SiH bonds.

Exemplary H-resins which may not be fully condensed include those described in U.S. Patent 5,010,159 or U.S. Patent 4,999,397. Exemplary H-resins which are not fully hydrolyzed or condensed are formed by a process which comprises hydrolyzing a hydrocarbonoxy hydridosilane with water in an acidified oxygen-containing polar organic solvent.

A platinum, rhodium or copper catalyst may also be admixed with the hydrogen silsesquioxane to increase the rate and extent of its conversion to silica. Any platinum, rhodium or copper compound or complex that can be solubilized with the catalyst will be operable. For instance, an organo-platinum composition such as platinum acetylacetonate or rhodium catalyst RhCl₃[S(CH₂CH₂CH₂CH₃)₂]₃, obtainable from Dow Corning Corporation, Midland, Michigan, are all within the scope of this invention. The above catalysts are generally added to the solution in an amount of between about 5 and 500 ppm platinum or rhodium based on the weight of resin.

The second type of silica precursor material useful herein includes hydrolyzed or partially hydrolyzed compounds of the formula RₙSi(OR)₄₋ₙ in which R and n are as defined above. Some of these materials are commercially available, for example, under the tradename ACCUGLASS. Specific compounds of this type include methyltriethoxysilane, phenyltriethoxysilane, diethyldiethoxysilane, methyltrimethoxysilane, dimethyldimethoxysilane, phenyltrimethoxysilane, vinyltrimethoxysilane, tetramethoxysilane, tetraethoxysilane, tetrapropoxysilane and tetrabutoxysilane. After hydrolysis or partial hydrolysis of these compounds, the silicon atoms therein may be bonded to C, OH or OR groups, but a substantial portion of the material is believed to be condensed in the form of soluble Si-O-Si resins. Compounds in which x = 2 or 3 are generally not used alone as volatile cyclic structures are generated during pyrolysis, but small amounts of said compounds may be cohydrolyzed with other silanes to prepare useful preceramic materials.

In addition to the above SiO₂ precursors, other ceramic oxide precursors may also be advantageously used herein either solely or in combination with the above SiO₂ precursors. The ceramic oxide precursors specifically contemplated herein include compounds of various metals such as aluminum, titanium, zirconium, tantalum, niobium and/or vanadium as well as various non-metallic compounds such as those of boron or phosphorous which may be dissolved in solution, hydrolyzed and subsequently pyrolyzed at relatively low temperatures to form ceramic oxides.

The above ceramic oxide precursor compounds generally have one or more hydrolyzable groups bonded to the above metal or non-metal, depending on the valence of the metal. The number of hydrolyzable groups to be included in these compounds is not critical as long as the compound is soluble in the solvent. Likewise, selection of the exact hydrolyzable substituent is not critical since these substituents are either hydrolyzed or pyrolyzed out of the system. Typical hydrolyzable groups include alkoxy, such as methoxy, propoxy, butoxy and hexoxy; acyloxy, such as acetoxy, other organic groups bonded to said metal or non-metal through an oxygen atom such as acetylacetonate or amino groups. Specific compounds, therefore, include zirconium tetracetylacetonate, titanium dibutoxy diacetylacetonate, aluminum triacetylacetonate, tetraisobutoxy titanium and Ti(N(CH₃)₂)₄.

When SiO₂ is to be combined with one of the above ceramic oxide precursors, generally it is used in an amount such that the final ceramic contains 70 to 99.9 percent by weight SiO₂.

Examples of suitable silicon carbonitride precursors include hydridopolysilazane (HPZ) resin and methylpolydisilylazane (MPDZ) resin. Processes for the production of these materials are described in US Patents 4,540,803 and 4,340,619. Examples of silicon carbide precursors include polycarbosilanes and examples of silicon nitride precursors include polysilazanes. Oxygen can be incorporated into the ceramics resulting from the above precursors by pyrolyzing them in an oxygen-containing environment.

The above preceramic material is then used to coat the integrated circuit. The material can be used in any practical form but it is preferred to use a solution comprising the preceramic material in a suitable solvent. If this solution approach is used, the preceramic solution is generally formed by simply dissolving or suspending the preceramic material in a solvent or mixture of solvents. Various facilitating measures such as stirring and/or heat may be used to assist in the dissolution. The solvents which may be used in this method include alcohols such as ethyl or isopropyl; aromatic hydrocarbons such as benzene or toluene; alkanes such as n-heptane or dodecane; ketones; cyclic dimethylpolysiloxanes; esters and glycol ethers, in an amount sufficient to dissolve the above materials to low solids. For instance, enough of the solvent should be included to form a 0.1-85 weight percent solution.

The circuit is then coated with this solution by means such as spin, spray, dip or flow coating and the solvent is allowed to evaporate. Any suitable means of evaporation such as simple air drying by exposure to the ambient environment, heating or the application of a vacuum may be used.

Although the above described methods primarily focus on using a solution approach, one skilled in the art would recognize that other equivalent means (eg., melt impregnation) would also function in the process of this invention.

The preceramic material is then typically converted to a silicon-containing ceramic by heating it to a sufficient temperature. Generally, the temperature is in the range of 50 to 800°C. depending on the pyrolysis atmosphere and the preceramic compound. Preferred temperatures are in the range of 50 to 600°C. and more preferably are 50-400°C. Heating is generally conducted for a time sufficient to ceramify, generally up to 6 hours, with less than 2 hours being preferred.

The above heating may be conducted at any effective atmospheric pressure from vacuum to superatmospheric and under any effective oxidizing or non-oxidizing gaseous environment such as those comprising air, O₂, an inert gas (N₂, etc.), ammonia, amines, moisture, N₂O and the like.

Any method of heating such as the use of a convection oven, rapid thermal processing, hot plate or radiant or microwave energy is generally functional herein. The rate of heating, moreover, is also not critical, but it is most practical and preferred to heat as rapidly as possible.

Additional coatings may be applied over these coatings if desired. These can include, for example, SiO₂ coatings, SiO₂/ceramic oxide layers, silicon-containing coatings, silicon-carbon containing coatings, silicon-nitrogen containing coatings, silicon-oxygen-nitrogen coatings, silicon-nitrogen-carbon containing coatings and/or diamond-like carbon coatings. Methods for the application of such coatings are known in the art and many are described in U.S. Patent 4,756,977. An especially preferred coating is silicon carbide applied by CVD of silacyclobutane as is described in U.S. Patent 5,011,706.

After the ceramic layers are applied, the coating covering the bond pads is etched or partially etched to allow for attachment of leads. The method of etching is not critical and nearly any process known in the art will function herein. This includes, for example, dry etching (eg., with plasma), wet etching (eg., with aqueous hydrofluoric acid) and/or laser ablation.

The above sealing processes can be performed at the wafer stage or after dicing. It is preferred herein, however, to seal the devices at the wafer stage for efficiency reasons.

The aperture of the open bond pad is generally decreased by this process such that the original etching in the primary passivation is further sealed and the ceramic layer is in intimate contact with the bond pad. In addition, any cracks, pinholes or defects in the original passivation are sealed. Furthermore, the coatings of the invention are often opaque to UV or visible light.

Such circuits are then interconnected with each other, with a lead frame, with a circuit board or other external components. Such interconnection can be by conventional leads or by methods such as TAB or "flip chip" processes which are well known in the art.

After interconnection, the device can also be packaged by conventional techniques known in the art. For instance, the device can be embedded within an organic encapsulant such as a polyimide, an epoxy or PARYLENE^{TM}. It can also be embedded within a silicon encapsulant or it can be included in a plastic package for additional protection.

## Claims

1. An integrated circuit having a primary passivation and one or more open bond pads, said circuit characterized by:
a ceramic layer covering the primary passivation, wherein the ceramic layer comprises a silicon-containing ceramic material which is deposited by a process comprising (A) coating the circuit with a composition comprising a preceramic silicon-containing material followed by (B) converting said material to a ceramic.

2. The integrated circuit of claim 1 wherein the ceramic layer is selected from the group consisting of silicon oxides, silicon nitride, silicon oxynitride, silicon oxycarbide, silicon carbonitride, silicon oxycarbonitride and silicon carbide.

3. The integrated circuit of claim 1 wherein the preceramic silicon-containing material is hydrogen silsesquioxane resin.

4. The integrated circuit of claim 1 wherein the preceramic silicon-containing material is a hydrolyzed, partially hydrolyzed or their combinations of a formula RₙSi(OR)₄₋ₙ, in which R is an aliphatic, alicyclic or aromatic substituent of 1-20 carbon atoms and n is 0-3.

5. The integrated circuit of claim 1 which has been interconnected and embedded within a material selected from organic encapsulants and silicone encapsulants.

6. The integrated circuit of claim 1 in which the ceramic layer is opaque to ultraviolet and visible light.

7. A method for hermetically sealing an integrated circuit having a primary passivation and one or more open bond pads, the method comprising:
(A) applying a silicon-containing ceramic layer to the integrated circuit by a process which comprises (i) coating the circuit with a composition comprising a preceramic silicon-containing material followed by (ii) converting said material to the silicon-containing ceramic; and
(B) removing at least a portion of the silicon-containing ceramic layer covering the bond pads.

8. An integrated circuit comprising:
(A) a circuit subassembly having bond pads;
(B) a primary passivation layer on the surface of the subassembly around the bond pads; and
(C) one or more ceramic layers covering the primary passivation layer;
characterized by one or more of the ceramic layers comprising a silicon-containing ceramic material which is deposited by a process comprising coating at least the primary passivation layer with a composition comprising a preceramic silicon-containing material followed by converting the preceramic material to a ceramic layer.
